# EUROPEAN PATENT SPECIFICATION

(11) **EP 1 656 820 B1**
(45) Date of publication and mention of the grant of the patent: **06.02.2008**
(21) Application number: 04772092.5
(22) Date of filing: 18.08.2004
(51) Int. Cl.: H05K 9/00, H01Q 17/00

(54) **ELECTROMAGNETIC WAVE ABSORBER**
ABSORBER FÜR ELEKTROMAGNETISCHE WELLEN
ABSORBEUR D'ONDES ELECTROMAGNETIQUES

(30) Priority: 18.08.2003 JP 2003294506
(43) Date of publication of application: 17.05.2006
(73) Proprietor: SHOWA DENKO KABUSHIKI KAISHA, Tokyo 105-8518 (JP)
(72) Inventor: HIRATA, M., c/o Corporate R & D Center (Kawasaki), Kawasaki-shi, Kanagawa 210-0867 (JP); UTSUNOMIYA, Masahide, c/o SHOWA DENKO K.K., Chichibu-shi, Saitama 369-1893 (JP)
(74) Representative: Henkel, Feiler & Hänzel
(86) International application number: PCT/JP2004/012131
(87) International publication number: WO 2005/018298

(56) References cited:
- JP-A- 54 127 000
- JP-A- 2001 053 487
- US-A- 4 046 727
- PATENT ABSTRACTS OF JAPAN vol. 2000, no. 16, 8 May 2001 (2001-05-08) & JP 2001 028491 A (DAIDO STEEL CO LTD), 30 January 2001 (2001-01-30) cited in the application
- PATENT ABSTRACTS OF JAPAN vol. 2000, no. 24, 11 May 2001 (2001-05-11) & JP 2001 200117 A (C I KASEI CO LTD), 24 July 2001 (2001-07-24) cited in the application
- PATENT ABSTRACTS OF JAPAN vol. 2000, no. 21, 3 August 2001 (2001-08-03) & JP 2001 119189 A (TOKIN CORP; TOHOKU KAKO KK), 27 April 2001 (2001-04-27) cited in the application

## Description

This application claims the priority of an application based on U.S. Provisional Application Serial No. 60/498,597 (filed on August 29, 2003).

### Technical Field

The present invention relates to an electromagnetic wave-absorbing material and, particularly to an electromagnetic wave-absorbing material which is suitably usable for various devices and apparatuses such as electronic devices.

### Background Art

with the recent developments in electronics, the miniaturization of the electronic devices and instruments, and higher frequency utilization are progressing year by year. Along with such miniaturization and higher frequency utilization in the electronic devices and instruments, some problems such as electromagnetic immunity and electromagnetic interference are becoming more serious year by year, based on those structural factors. Therefore, effective measures to solve these problems are eagerly desired.

As one of these measures to solve the above problems, the use of an electromagnetic wave absorber is expected. In general, the electromagnetic wave absorbers are produced in the form of a flexible sheet, and can reduce the noise due to electromagnetic waves by a method wherein the electromagnetic wave absorber is attached or bonded to, or is wrapovered an electromagnetic wave-emitting source. Accordingly, the electromagnetic wave absorbers are usually called electromagnetic wave-absorbing sheets, noise-suppression sheets, etc.

As an example of an electromagnetic wave absorber, one comprising chlorinated polyethylene and soft magnetic powder mixed therein is known (as disclosed in Patent Document 1). However, this electromagnetic wave absorber has a problem that it produces a halogen-containing gas when the absorber is incinerated to be disposed. Further, there is known another type of electromagnetic wave absorber, which uses a rubber material containing no halogen such as NBR and EPR, as a base polymer (as disclosed in Patent document 2).

However, in both cases of these electromagnetic wave absorbers, the soft magnetic powder constituting the electromagnetic wave absorber is liable to be deteriorated, or an object to which the electromagnetic wave absorber is to be applied (i.e., electronic device) is liable to contaminated by a curing (or vulcanizing) agent, which has been used at the time of the curing or vulcanization of the polymer constituting the electromagnetic wave absorber. On this account, the above-mentioned electromagnetic wave absorbers are used without curing or vulcanization thereof. Accordingly, the conventional electromagnetic wave absorbers cause various kinds of problems. For example, the conventional electromagnetic wave absorbers have a tendency such that they have an insufficient strength, have a poor resistance to chemical agents, cause a problem of blocking, have a poor heat resistance, etc.

Further, an electromagnetic wave absorber using a silicone rubber has also been proposed (as disclosed in Patent Document 3). However, an impurity contained in the silicone rubber can deteriorate the electronic devices as the objects to which the electromagnetic wave absorbers are to be applied.
[Patent document 1] JP-A (Japanese Unexamined Patent Publication; KOKAI) 2001-028491
[Patent document 2] JP-A 2001-200117
[Patent document 3] JP-A 2001-119189

### Disclosure of Invention

An object of the present invention is to provide an electromagnetic wave absorber, which can solve the problem encountered in the prior art as described above.

Another object of the present invention is to provide an electromagnetic wave absorber, which has sufficient electromagnetic wave-absorbing property, flexibility, good strength, and resistance to chemical agents, and good heat resistance.

The present inventors have found that the above-mentioned object has been achieved, by a composition comprising a compound having two or more carboxyl groups in one molecule thereof, a multi-functional epoxide compound, and soft magnetic powder and thermally curing the composition comprising these compounds. The present inventors have accomplished the present invention based on this discovery.

More specifically, the present invention includes, e.g., the following embodiments [1]-[7].
[1] An electromagnetic wave-absorbing material composition, comprising:
   (A) a compound having two or more carboxyl groups and/or an acid anhydride group thereof, in one molecule of the compound;
   (B) a compound having two or more epoxy groups in one molecule thereof; and
   (C) a soft magnetic powder.
[2] An the electromagnetic wave-absorbing material composition according to [1], which comprises:
   (A) 25-99 mass parts of the compound having two or more carboxyl groups and/or an acid anhydride group thereof, in one molecule of the compound; and
   (B) 1-50 mass parts of the compound having two or more epoxy groups in one molecule thereof, with respect to 100 mass parts of the subtraction weight, which has been obtained by subtracting the weight of the soft magnetic powder (C) from the total weight of the electromagnetic wave-absorbing material composition.
[3] The electromagnetic wave-absorbing material composition according to [1] or [2], which comprises (C) 200-900 mass parts of soft magnetic powder, with respect to 100 mass parts of the subtraction weight, which has been obtained by subtracting the weight of the soft magnetic powder (C) from the total weight of the electromagnetic wave-absorbing material composition.
[4] The electromagnetic wave-absorbing material composition according to [1] or [2], wherein the compound having two or more carboxyl groups and/or an acid anhydride group thereof, in one molecule of the compound is a rubber-like polymer.
[5] The electromagnetic wave-absorbing material composition according to [1] or [2], wherein the soft magnetic powder is an amorphous metal, a soft magnetic metal or a ferrite compound.
[6] An electromagnetic wave absorber, which has been provided by subjecting an electromagnetic wave-absorbing material composition to a crosslinking reaction, wherein the electromagnetic wave-absorbing material composition comprises:
   (A) a compound having two or more carboxyl groups and/or an acid anhydride group thereof, in one molecule of the compound;
   (B) a compound having two or more epoxy groups in one molecule thereof; and
   (C) a soft magnetic powder.
[7] An electromagnetic wave-absorbing sheet, which has been provided by subjecting an electromagnetic wave-absorbing material composition to a crosslinking reaction, wherein the electromagnetic wave-absorbing material composition comprises:
   (A) a compound having two or more carboxyl groups and/or an acid anhydride group thereof, in one molecule of the compound;
   (B) a compound having two or more epoxy groups in one molecule thereof; and
   (C) a soft magnetic powder.

In the present invention, the electromagnetic wave absorber may preferably contain substantially no halogen atom (more preferably 0.2 mass % or less, based on the total mass of the electromagnetic wave absorber).

### Best Mode for Carrying Out the Invention

Hereinbelow, the present invention will be described in detail. In the following description, "%" and "part(s)" representing a quantitative proportion or ratio are those based on mass, unless otherwise specifically noted.

### (Electromagnetic wave absorber)

The electromagnetic wave-absorbing material composition according to the present invention is a composition, which comprises: (A) a compound having two or more carboxyl groups and/or an acid anhydride group thereof, in one molecule of the compound, (B) a compound having two or more epoxy groups in one molecule thereof, and (C) a soft magnetic powder.

The electromagnetic wave absorber according to the present invention can be obtained, e.g., by thermally curing (or crosslinking) a composition, which comprises: (A) a compound having two or more carboxyl groups and/or an acid anhydride group thereof, in one molecule of the compound, (B) a compound having two or more epoxy groups in one molecule thereof, and (C) a soft magnetic powder.

### Compound (A))

The compound having two or more carboxyl groups and/or an acid anhydride group thereof, in one molecule of the compound, as compound (A), may preferably be a polymer compound having a relatively high molecular weight. The molecular weight may preferably be 1×10⁴ or more, more preferably 2×10⁴ or more, further preferably 5x10⁴ or more, in terms of the weight-average molecular weight (i.e., molecular weight in polystyrene conversion as determined by GPC (gel permeation chromatography) measurement). However, when the molecular weight of the polymer compound becomes too high, the soft magnetic powder is less liable to be combined or mixed in such a compound. In this point of view, the molecular weight may preferably be 1×10⁶ or less, more preferably 5×10⁵ or less.

Further, compound (A) may preferably be a rubber-like (or elastomeric) polymer compound. When the compound (A) is a rubber-like polymer compound, the resultant electromagnetic wave absorber has an appropriate flexibility, and therefore it can be attached or applied to an electromagnetic wave-generating source having various kinds of shapes so as to provide a close or intimate contact therebetween. Herein, the "rubber-like polymer compound" refers to a polymer compound showing a so-called rubber-like elasticity at normal (or room) temperature (e.g., 25°C). The polymer compound showing a rubber-like elasticity may preferably be one having a Tg (glass transition point) of 0°C or lower. Herein, Tg may be measured by DSC (JIS K7121).

Examples of the compound (A) may include: homopolymers of monobasic carboxylic acid or ester thereof having at least one double bond (such as acrylic acid, methacrylic acid, and vinyl acetate), and copolymers thereof with another monomer, and hydrogenated products of these polymers; copolymers of a dibasic acid having at least one double bond (such as maleic acid) and/or acid anhydrides thereof (such as maleic anhydride, and Himic anhydride (i.e., 5-norbornene-2,3-dicarboxylic anhydride)) and another monomer; products obtained by reacting a poly carboxylic acid and a polyol; products obtained by the addition reaction of a multivalent (or polybasic) carboxylic acid with an epoxide compound; products obtained by the addition reaction of an acid anhydride with a compound having a hydroxyl group, etc.

Examples of the above copolymerizable "another monomer" may include: acrylic acid esters such as ethyl acrylate and methyl acrylate, methacrylic acid esters such as methyl methacrylate, and monomers having an ethylenically unsaturated bond such as styrene, acrylonitrile, ethylene, propylene, and vinyl acetate.

Specific examples of the compound (A) may include: Vamac^{™} G, Vamac^{™} GLS, and Vamac^{™} HVG which are acid-modified ethylene acrylic rubbers (mfd. by Dupont-Mitsui Polychemicals Co., Ltd.), Nipol^{™} 1072, Nipol^{™} 1072J, and Nipol^{™} DN631, which are acrylonitrile-butadiene-methacrylic acid copolymers (mfd. by Nippon Zeon Co.,Ltd.), and the hydrogenated product of these polymers, and compounds having two or more carboxyl groups and/or acid anhydride group thereof. These components may be used singly or as a mixture or combination of two or more kinds thereof.

### Compound (B))

The compound having two or more epoxy groups in one molecule thereof (compound (B)) usable in the present invention is not particularly limited, as long as it has a reactivity with the above-mentioned compound (A). In view of easy handling and availability, specific examples of the compound (B) may include: e.g., bispenol A-type epoxy resins, hydrogenated bispenol A-type epoxy resins, brominated bispenol A-type epoxy resins, bisphenol F-type epoxy resins, Novolak-type epoxy resins, phenol Novolak-type epoxy resins, cresol Novolak-type epoxy resins, Novolak-type epoxy resins of bispenol A, chelate-type epoxy resins, glyoxal-type epoxy resins, polysulfide-type epoxy resins, amino group-containing epoxy resins, rubber-modified epoxy resins, dicyclopentadiene phenolic-type epoxy resins, silicone-modified epoxy resins, ε-caprolactone-modified epoxy resins, N-glycidyl-type epoxy resins, bisphenol-S-type epoxy resins, diglycidyl phthalate resins, heterocyclic epoxy resins, bixylenol-type epoxy resins, biphenol-type epoxy resins and tetraglycidyl xylenoylethane resins, Bond First^{™} 2B and 7B which are ethylene-glycidy methacrylate-vinyl acetate copolymers (mfd. by Sumitomo Chemical Co., Ltd.) and Epiclon^{™} products (mfd. by Dainippon Ink And Chemicals, Inc.) which are phosphorus-containing epoxy resins having fire retardance. These components may be used singly or as a mixture or combination of two or more kinds thereof.

### (Rubber compound having no carboxyl group)

The electromagnetic wave-absorbing material according to the present invention may also contain a rubber (or rubber-like) compound having no carboxyl group, and/or an epoxide compound having one epoxy group in one molecule thereof, as desired. Examples of the rubber compound may include: rubber components having no carboxyl group, such as NBR (acrylonitrile-butadiene rubber), silicone rubbers, chlorinated polyethylenes, EPR (ethylene-propylene rubber), EPDM, (ethylene-propylenediene terpolymer), polyurethane rubbers, olefinic-type thermoplastic elastomers, and styrene-type thermoplastic elastomers. The amount of the rubber compound having no carboxyl group, and/or epoxide compound having one epoxy group in one molecule thereof is not particularly limited, as long as they does not substantially impair the characteristic of the composition according to the present invention. In view of the strength and heat resistance, the amount of the rubber compound having no carboxyl group, and/or epoxide compound having one epoxy group in one molecule thereof may preferably be 15 mass parts or less (more preferably 10 mass parts or less), with respect to the total 100 mass parts of the above-mentioned compounds (A) and (B).

### (Composition)

In the present invention, the amount of the compound (A) having two or more carboxyl groups and/or an acid anhydride group thereof, in one molecule of the compound, may preferably be 25-99 mass parts, with respect to 100 mass parts of the subtraction weight, which has been obtained by subtracting the weight of the soft magnetic powder (C) from the total weight of the electromagnetic wave-absorbing material composition. That is, when the total weight of the electromagnetic wave-absorbing material composition is denoted by Wt, and the weight of the soft magnetic powder (C) is denoted by Wc, the subtraction weight Ws is (Wt-Wc).

When the amount of the compound (A) is less than 25 mass parts, the tensile strength and resistance to chemical agents are liable to be insufficient. On the other hand, when the amount of the compound (A) exceeds 99 mass parts, the tensile strength and resistance to chemical agents are also liable to be decreased.

In the present invention, the amount of the compound (B) having two or more epoxy groups in one molecule thereof, may preferably be 50-1 mass parts, with respect to 100 mass parts of the subtraction weight, which has been obtained by subtracting the weight of the soft magnetic powder (C) from the total weight of the electromagnetic wave-absorbing material composition. When the amount of the compound (B) exceeds 50 mass parts, the flexibility is liable to be deteriorated. On the other hand, when the amount of the compound (B) is less than 1 mass part, the crosslinking density tends to be decreased so that the tensile strength and resistance to chemical agents are also liable to be insufficient.

### (Soft magnetic powder (C))

In the present invention, the "soft magnetic powder" refers to a powder of a material, which is ferromagnetic and has a high magnetic permeability and a low coercivity. The soft magnetic powder (C) to be used in the present invention may preferably have a good magnetic permeability in a high frequency range. More specifically, the soft magnetic powder (C) may more preferably have a magnetic permeability maximum value of 50 or more in high-frequency range of 1 MHz-10 GHz. Such a magnetic permeability can be measured in various waveguides. Specific examples of the soft magnetic powder (C) may include: e.g., Permalloy, Sendust, Fe-Si, Fe-Si-Cr, carbonyl iron, and amorphous soft magnetic metals such as Fe-Si-B type material. Further, it is also possible to use oxide-type ferrite, such as Mn-Zn ferrite, and Ni-Zn ferrite. However, the soft magnetic powder (C) usable in the present invention is not particularly limited to the above specific examples thereof, but may be selected from wide range of soft magnetic powders.

The shape or form of the soft magnetic powder is not particularly limited, but may be any of spherical, granular and flat or oblate-type powders. These soft magnetic powders may be used singly or as a mixture of two or more kinds thereof.

The particle size of the soft magnetic powder is not particularly limited, but may preferably be 1-500 µm, more preferably 10-200 µm, particularly 10-80 µm, in terms of the average particle size D50 as measured by a laser diffraction particle size distribution analyzer. Herein, "D50" denotes the median valve based on mass.

When the flat-type powder is used, the thickness "t" of the soft magnetic powder may preferably be 0.1-10 µm, more preferably 0.1-5 µm, particularly 0.1-2 µm, in terms of the average thickness as measured by a scanning electron microscope. Further, the average aspect ratio may preferably be 1-1000, more preferably 5-200, particularly 10-100, in terms of the ratio (D50/t), which has been determined from the average particle size D50 as measured by a laser diffraction particle size distribution analyzer, and the average thickness "t" as measured by a scanning electron microscope. However, the average aspect ratio usable in the present invention is not limited to these specific ranges.

The amount of the soft magnetic powder (C) in the composition according to the present invention may preferably be 200-900 mass parts, more preferably 300-900 mass parts, with respect to 100 mass parts of the subtraction weight, which has been obtained by subtracting the weight of the soft magnetic powder (C) from the total weight of the electromagnetic wave-absorbing material composition. When the amount of the soft magnetic powder (C) is less than 200 mass parts, the electromagnetic wave-absorbing property is liable to be insufficient. On the other hand, when the amount of the soft magnetic powder (C) exceeds 900 mass parts, the flexibility is liable to be deteriorated.

### (Additives)

As desired, the composition according to the present invention can contain at least one of various additives such as antioxidants, age resistors, fire retardants, fire retardant aids, plasticizers, curing (or crosslinking) agents, and solvents. The amount of the additive(s) is not particularly limited, as long as the addition of such an additive does not substantially impair the characteristic of the composition according to the present invention. In the present invention, the fire retardant may preferably be one containing no bromine, but may be phosphorus-containing compounds such as polyphosphoric acid ammonium and polyphosphoric acid melamine, and thermally expanding graphites, metal hydrates, etc.

### (Catalyst)

When the electromagnetic wave-absorbing material composition according to the present invention is cured or crosslinked, it is possible to use various catalysts (or curing agents), as desired. In view of the handling thereof and a uniform or homogeneous reaction therefor, the catalyst may preferably be a thermal curing catalyst.

### (Thermal curing catalyst (E))

The thermal curing catalyst (E) to be used in the present invention is not particularly limited, as long as the electromagnetic wave-absorbing material composition according to the present invention can be cured or hardened by such a catalyst. Preferred examples of the thermal curing catalyst (E) usable in the present invention may include: amines such as primary amines, secondary amines, and tertiary amines; amine salts such as chlorides of these amines; quaternary ammonium salts; acid anhydrides such as alicyclic acid anhydrides, aliphatic acid anhydrides and aromatic acid anhydrides; polyamides, nitrogen-containing heterocyclic compounds such as imidazole and triazine compounds; and organometallic compounds, etc. These catalysts may be used singly or as a mixture or combination of two or more kinds thereof, as desired.

### (Production process)

The process for producing the electromagnetic wave-absorbing material composition according to the present invention is not particularly limited. For example, when the electromagnetic wave-absorbing material composition according to the present invention is produced by mixing the respective compounds constituting the composition, it is possible to use a kneading machine such as a kneader, a mixing roll, and an intensive mixer, or to dissolve or disperse the respective compounds in a solvent.

### (Molding method)

The method of processing or molding the electromagnetic wave-absorbing material composition according to the present invention is not particularly limited. When the electromagnetic wave-absorbing material composition according to the present invention is formed into a desired shape, it is possible to use a molding method such as roll molding, extrusion molding, press molding, and injection molding, or a method wherein the electromagnetic wave-absorbing material composition is dissolved or dispersed into a solvent, the resultant solution or dispersion is applied onto an appropriate substrate, and then the resultant coating is dried. It is also possible to combine a plurality of these molding methods, as desired.

When the electromagnetic wave-absorbing material composition after the molding thereof is intended to be crosslinked, it is possible to adopt an arbitrary method such as one wherein the composition is placed in a heating furnace, or the composition is cured or crosslinked while being pressed by a heat press.

Hereinbelow, the present invention will be described in more detail with reference to Examples.

### Examples

### Example 1

According to the formulation as shown in Table 1 appearing hereinafter, 97 g of Vamac^{™} G (mfd. by Mitsui-Dupont Polychemical Co.) as a compound (A) having a carboxyl group and/or an acid anhydride group thereof; 3 g of Flep^{™} 60 (mfd. by Toray Finechemical Co.) as a compound (B) having two or more epoxy groups in one molecule thereof; and 0.15 g of Curesol^{™} 2MA-OK (mfd. by Shikoku Kasei Co., Ltd.) which is 2-aminoimidazole isocyanuric acid adduct as a curing agent were dissolved in 400 g of toluene. Then, 700 g of Sendust flat-type powder (D50 = 20 µm, average thickness 1 µm, average aspect ratio =20) as soft magnetic powder (C) was added to the thus obtained toluene solution, and the resultant mixture was subjected to stirring and mixing, to thereby provide a toluene dispersion/solution of an electromagnetic wave-absorbing material composition.

The resultant dispersion/solution of the electromagnetic wave-absorbing material composition was applied onto the silicone-coated surface of a silicone-coated PET film (thickness of film portion 25 µm; mfd. by Mitsubishi Polyester Co., Ltd.; trade name: MRF25), and then dried at 80°C for seven minutes. Thereafter, the resultant coating layer was peeled from the silicone-coated PET film, to thereby obtain an electromagnetic wave-absorbing material composition having a formulation as shown in Table 1 appearing hereinafter.

The thus obtained electromagnetic wave-absorbing material composition was subjected to crosslinking in a heat press (pressure: 5 MPa) at 150°C for one hour, to thereby obtain a 100 µm-thick sheet-shaped sample of the electromagnetic wave absorber.

### Comparative Example 1

An electromagnetic wave absorber sample was obtained in the same manner as in Example 1, except that Vamac^{™} D (mfd. by Mitsui/Dupont Polychemical Co.) having no carboxyl group was used instead of Vamac G used in Example 1. The formulation used herein is shown in Table 1 appearing hereinafter.

### Comparative Example 2

An electromagnetic wave-absorbing material composition was obtained in the same manner as in Example 1, except that the epoxide compound and the curing agent were not used. The thus obtained composition was subjected to pressing (pressure: 5 MPa) at normal temperature (i.e., without crosslinking), to thereby obtain a 100 µm-thick sheet-shaped sample of the electromagnetic wave absorber.

### Example 2, Comparative Examples 3-4

Each of the electromagnetic wave absorber samples was obtained in the same manner as in Example 1, except for using the corresponding electromagnetic wave-absorbing material composition having a formulation as shown in Table 1 appearing hereinafter.

### Examples 3-8

Each of the 100 µm-thick sheet-shaped electromagnetic wave absorber samples was obtained in the same manner as in Example 1, except for using the corresponding compounds according to the formulation as shown in Table 3 appearing hereinafter. More specifically, in these examples, Vamac^{™} G (mfd. by Mitsui-Dupont Polychemical Co.) and/or Nipol^{™} 1072J (mfd. by Nippon Zeon Co.,Ltd.) were used as a compound (A) having a carboxyl group and/or an acid anhydride group thereof; Flep^{™} 60 (mfd. by Toray Fine Chemical Co.) and/or Epiclon^{™} 850S (mfd. by Dainippon Ink And Chemicals, Inc.) were as a compound (B) having two or more epoxy groups in one molecule thereof; Curesol 2MA-OK (mfd. by Shikoku Kasei Co., Ltd.) which is 2-aminoimidazole isocyanuric acid adduct was used as a curing agent; aluminum hydroxide (Higilite^{™} H-43STE, mfd. by Showa Denko K.K.), polyphosphoric acid ammonium (Exolit AP422, mfd. by Clariant Japan Co.), and thermally expanding graphite (Fine Powder TEG, mfd. by Air-Water Chemical Co. (former name: Sumikin Air-Water Chemical Co.)) were used as a fire retardant; and Sendust flat-type powder (D50 = 20 µm, average thickness 1 µm, average aspect ratio =20) was used as soft magnetic powder (C).

### Comparative Examples 5-6

Each of the electromagnetic wave absorber samples was obtained in the same manner as in Example 1, except for using the corresponding electromagnetic wave-absorbing material composition having a formulation as shown in Table 3 appearing hereinafter.

### Evaluation of electromagnetic wave absorbers

Various properties of the respective samples were tested and evaluated in the following manner.

### (1) Electromagnetic wave absorption ratio

An electromagnetic wave absorber sheet (50 mm x 50 mm x 0.1 mm thickness) to be evaluated was placed on the microstrip line (characteristic impedance 50 Ω) connected to a network analyzer (HP8510, mfd. by Hewlett-Packard Co.), and the electromagnetic wave absorption ratio of the sheet was evaluated from the transmission loss S21 of the S-parameter. The values of the S21 of the respective samples at 3 GHz, which were measured by the above method are shown in Tables 2 and 4 appearing hereinafter.

### (2) Flexibility

A 100 µm-thick sample to be evaluated was bent so as to provide an angle of 180 degrees (i.e., the sample was bent so as to provide a hairpin-like shape), and the occurrence of fractures and cracks in the neighborhood of the bent portion was visually observed with the naked eye. The results of the observation were judged in the following manner. The thus obtained results are shown in Tables 2 and 4 appearing hereinafter.
○: No crack was observed.
×: Fractures and/or cracks (having a length of 500 µm or more) were observed.

### (3) Resistance to chemical agents

A 100 µm-thick sample was immersed in toluene at room temperature for 18 hours, and the presence or absence of a dissolved portion in the sample surface was judged by observing the sample surface. More specifically, this judge was based on whether unevenness was observed on the sample surface, or whether powdery matter was observed in the toluene. The thus obtained results are shown in Tables 2 and 4 appearing hereinafter.

### (4) Tensile strength

The tensile break strength of a sample to be evaluated having a thickness of 100 µm, a width of 15 mm and a length of 120 mm was measured by using a tensile tester (Tensilon UTM-III 500 Model, mfd. by Toyo Baldwin Co.) in a thermostatic chamber of 23°C under the conditions of a pulling rate of 50 mm/min., and a distance between chucks of 100 mm. The thus obtained results are shown in the following Tables 2 and 4.

**Table 1**

| | | Ex. 1 | Ex. 2 | Comp. Ex. 1 | Comp. Ex. 2 | Comp. Ex. 3 | Comp. Ex. 4 |
|---|---|---|---|---|---|---|---|
| VamacG | mass parts | 97 | 97 | - | 100 | 40 | 97 |
| VamacD | mass parts | - | - | 97 | - | - | - |
| Flep60 | mass parts | 3 | 3 | 3 | - | 60 | 3 |
| curing agent | mass parts | 0.15 | 0.15 | 0.15 | - | 3 | 0.15 |
| soft magnetic powder | mass parts | 700 | 400 | 700 | 700 | 700 | 950 |

**Table 2**

| | electromagnetic wave absorption ratio dB | flexibility | chemical resistance | tensile strength kg/cm2 |
|---|---|---|---|---|
| Ex. 1 | -2.0 | ○ | ○ | 13 |
| Ex. 2 | -1.5 | ○ | ○ | 11 |
| Comp. Ex. 1 | -1.9 | ○ | × | 1.1 |
| Comp. Ex. 2 | -2.1 | ○ | × | 2.8 |
| Comp. Ex. 3 | -1.9 | × | ○ | 66 |
| Comp. Ex. 4 | -2.7 | × | ○ | 41 |

**Table 3**

| | | Ex. 3 | Ex. 4 | Ex. 5 | Ex. 6 | Ex. 7 | Ex. 8 | Comp. Ex. 5 | Comp. Ex. 6 |
|---|---|---|---|---|---|---|---|---|---|
| VamacG | mass parts | - | 37.7 | - | 28.0 | 27.9 | 29.8 | - | 7.0 |
| Nipo11072J | mass parts | 56.9 | - | 29.3 | - | - | - | 56.9 | - |
| Flep6O | mass parts | - | 7.0 | 12.0 | 21.0 | - | - | - | - |
| EPICLON 850S | mass parts | 3.0 | - | 3.0 | - | 30.0 | 45.0 | 3.0 | 60.0 |
| Aluminum hydroxide | mass parts | 40.0 | - | 55.0 | - | - | 25.0 | 40.0 | 30.0 |
| polyphosphoric acid ammonium | mass parts | - | 25.0 | - | 50.0 | 20.0 | - | - | - |
| thermally expanding graphite | mass parts | - | 30.0 | - | - | 22.0 | - | - | - |
| hardening agent | mass parts | 0.15 | 0.30 | 0.75 | 1.00 | 0.15 | 0.20 | 0.15 | 3.00 |
| Subtotal | | 100.00 | 100.00 | 100.00 | 100.00 | 100.00 | 100.00 | 100.00 | 100.00 |
| soft magnetic powder | mass parts | 220 | 250 | 300 | 400 | 600 | 900 | 150 | 850 |

**Table 4**

| | electromagnetic wave absorption ratio dB | flexibility | chemical resistance | tensile strength kg/cm2 |
|---|---|---|---|---|
| Ex. 3 | -1.2 | ○ | ○ | 14 |
| Ex. 4 | -1.4 | ○ | ○ | 16 |
| Ex. 5 | -1.5 | ○ | ○ | 18 |
| Ex. 6 | -1.5 | ○ | ○ | 21 |
| Ex. 7 | -1.8 | ○ | ○ | 22 |
| Ex. 8 | -2.5 | ○ | ○ | 24 |
| Comp. Ex. 5 | -0.3 | ○ | ○ | 8 |
| Comp. Ex. 6 | -2.6 | × | ○ | 46 |

### Industrial Applicability

As described hereinabove, the present invention provides an electromagnetic wave-absorbing material composition which includes: (A) a compound having two or more carboxyl groups and/or an acid anhydride group thereof, in one molecule of the compound; (B) a compound having two or more epoxy groups in one molecule thereof; and (C) a soft magnetic powder.

The present invention may also provide an electromagnetic wave absorber which contains substantially no halogen (the halogen atom content may preferably be 0.2 mass % or less), and is excellent in flexibility, chemical resistance, and strength.

## Claims

1. An electromagnetic wave-absorbing material composition, comprising:
(A) a compound having two or more carboxyl groups and/or an acid anhydride group thereof, in one molecule of the compound;
(B) a compound having two or more epoxy groups in one molecule thereof; and
(C) a soft magnetic powder.

2. An the electromagnetic wave-absorbing material composition according to claim 1, which comprises:
(A) 25-99 mass parts of the compound having two or more carboxyl groups and/or an acid anhydride group thereof, in one molecule of the compound; and
(B) 1-50 mass parts of the compound having two or more epoxy groups in one molecule thereof, with respect to 100 mass parts of the subtraction weight, which has been obtained by subtracting the weight of the soft magnetic powder (C) from the total weight of the electromagnetic wave-absorbing material composition.

3. The electromagnetic wave-absorbing material composition according to claim 1 or 2, which comprises (C) 200-900 mass parts of soft magnetic powder, with respect to 100 mass parts of the subtraction weight, which has been obtained by subtracting the weight of the soft magnetic powder (C) from the total weight of the electromagnetic wave-absorbing material composition.

4. The electromagnetic wave-absorbing material composition according to claim 1 or 2, wherein the compound having two or more carboxyl groups and/or an acid anhydride group thereof, in one molecule of the compound is a rubber-like polymer.

5. The electromagnetic wave-absorbing material composition according to claim 1 or 2, wherein the soft magnetic powder is an amorphous metal, a soft magnetic metal or a ferrite compound.

6. An electromagnetic wave absorber, which has been provided by subjecting an electromagnetic wave-absorbing material composition to a crosslinking reaction, wherein the electromagnetic wave-absorbing material composition comprises:
(A) a compound having two or more carboxyl groups and/or an acid anhydride group thereof, in one molecule of the compound;
(B) a compound having two or more epoxy groups in one molecule thereof; and
(C) a soft magnetic powder.

7. An electromagnetic wave-absorbing sheet, which has been provided by subjecting an electromagnetic wave-absorbing material composition to a crosslinking reaction, wherein the electromagnetic wave-absorbing material composition comprises:
(A) a compound having two or more carboxyl groups and/or an acid anhydride group thereof, in one molecule of the compound;
(B) a compound having two or more epoxy groups in one molecule thereof; and
(C) a soft magnetic powder.

## Patentansprüche

1. Elektromagnetische Wellen absorbierende Materialzusammensetzung, die umfasst:
(A) eine Verbindung mit zwei oder mehr Carboxylgruppen und/oder einer Säureanhydridgruppe derselben in einem Molekül der Verbindung;
(B) eine Verbindung mit zwei oder mehr Epoxygruppen in einem Molekül derselben; und
(C) ein magnetisch weiches Pulver.

2. Elektromagnetische Wellen absorbierende Materialzusammensetzung nach Anspruch 1, die umfasst:
(A) 25-99 Massenteile der Verbindung mit zwei oder mehr Carboxylgruppen und/oder einer Säureanhydridgruppe derselben in einem Molekül der Verbindung; und
(B) 1-50 Massenteile der Verbindung mit zwei oder mehr Epoxygruppen in einem Molekül derselben in Bezug auf 100 Massenteile des Subtraktionsgewichts, das durch Subtraktion des Gewichts des magnetisch weichen Pulvers (C) vom Gesamtgewicht der elektromagnetische Wellen absorbierenden Materialzusammensetzung erhalten wird.

3. Elektromagnetische Wellen absorbierende Materialzusammensetzung nach Anspruch 1 oder 2, die (C) 200-900 Massenteile eines magnetisch weichen Pulvers in Bezug auf 100 Massenteile des Subtraktionsgewichts, das durch Subtraktion des Gewichts des magnetisch weichen Pulvers (C) vom Gesamtgewicht der elektromagnetische Wellen absorbierenden Materialzusammensetzung erhalten wird, umfasst.

4. Elektromagnetische Wellen absorbierende Materialzusammensetzung nach Anspruch 1 oder 2, wobei die Verbindung mit zwei oder mehr Carboxylgruppen und/oder einer Säureanhydridgruppe derselben in einem Molekül der Verbindung ein kautschukähnliches Polymer ist.

5. Elektromagnetische Wellen absorbierende Materialzusammensetzung nach Anspruch 1 oder 2, wobei das magnetisch weiche Pulver ein amorphes Metall, ein magnetisch weiches Metall oder eine Ferritverbindung ist.

6. Absorber für elektromagnetische Wellen, der durch Durchführen einer Vernetzungsreaktion an einer elektromagnetische Wellen absorbierenden Materialzusammensetzung bereitgestellt wird, wobei die elektromagnetische Wellen absorbierende Materialzusammensetzung
(A) eine Verbindung mit zwei oder mehr Carboxylgruppen und/oder einer Säureanhydridgruppe derselben in einem Molekül der Verbindung;
(B) eine Verbindung mit zwei oder mehr Epoxygruppen in einem Molekül derselben; und
(C) ein magnetisch weiches Pulver umfasst.

7. Elektromagnetische Wellen absorbierende Lage, die durch Durchführen einer Vernetzungsreaktion an einer elektromagnetische Wellen absorbierenden Materialzusammensetzung bereitgestellt wird, wobei die elektromagnetische Wellen absorbierende Materialzusammensetzung
(A) eine Verbindung mit zwei oder mehr Carboxylgruppen und/oder einer Säureanhydridgruppe derselben in einem Molekül der Verbindung;
(B) eine Verbindung mit zwei oder mehr Epoxygruppen in einem Molekül derselben; und
(C) ein magnetisch weiches Pulver umfasst.

## Revendications

1. Composition de matériau absorbant les ondes électromagnétiques, comprenant :
(A) un composé ayant deux, ou plus, groupes carboxyle et/ou un groupe anhydride d'acide de celui-ci, dans une molécule du composé ;
(B) un composé ayant deux, ou plus, groupes epoxy dans une molécule de celui-ci ; et
(C) une poudre magnétique douce.

2. Composition de matériau absorbant les ondes électromagnétiques selon la revendication 1, qui comprend :
(A) 25 à 99 parties en masse du composé ayant deux, ou plus, groupes carboxyle et/ou un groupe anhydride d'acide de celui-ci, dans une molécule du composé ; et
(B) 1 à 50 parties en masse du composé ayant deux, ou plus, groupes époxy dans une molécule de celui-ci, par rapport à 100 parties en masse du poids de soustraction qui a été obtenu en soustrayant le poids de la poudre magnétique douce (C) du poids total de la composition de matériau absorbant les ondes électromagnétiques.

3. Composition de matériau absorbant les ondes électromagnétiques selon la revendication 1 ou 2, qui comprend (C) 200 à 900 parties en masse de poudre magnétique douce, par rapport à 100 parties en masse du poids de soustraction qui a été obtenu en soustrayant le poids de la poudre magnétique douce (C) du poids total de la composition de matériau absorbant les ondes électromagnétiques.

4. Composition de matériau absorbant les ondes électromagnétiques selon la revendication 1 ou 2, dans laquelle le composé ayant deux, ou plus, groupes carboxyle et/ou un groupe anhydride d'acide de celui-ci, dans une molécule du composé est un polymère du genre caoutchouc.

5. Composition de matériau absorbant les ondes électromagnétiques selon la revendication 1 ou 2, dans laquelle la poudre magnétique douce est un métal amorphe, un métal magnétique doux ou un composé ferritique.

6. Absorbeur d'ondes électromagnétiques, qui a été obtenu en soumettant une composition de matériau absorbant les ondes électromagnétiques à une réaction de réticulation, dans laquelle la composition de matériau absorbant les ondes électromagnétiques comprend :
(A) un composé ayant deux, ou plus, groupes carboxyle et/ou un groupe anhydride d'acide de celui-ci, dans une molécule du composé ;
(B) un composé ayant deux, ou plus, groupes epoxy dans une molécule de celui-ci ; et
(C) une poudre magnétique douce.

7. Feuille absorbant des ondes électromagnétiques, qui a été obtenue en soumettant une composition de matériau absorbant les ondes électromagnétiques à une réaction de réticulation, dans laquelle la composition de matériau absorbant les ondes électromagnétiques comprend :
(A) un composé ayant deux, ou plus, groupes carboxyle et/ou un groupe anhydride d'acide de celui-ci, dans une molécule du composé ;
(B) un composé ayant deux, ou plus, groupes epoxy dans une molécule de celui-ci ; et
(C) une poudre magnétique douce.
